(19) Europäisches Patentamt
European Patent Office
Office européen des brevets

(11) Publication number: **0 096 895**
**A2**

(12) # EUROPEAN PATENT APPLICATION

(21) Application number: 83105867.2

(51) Int. Cl.³: G 03 F 7/10

(22) Date of filing: 15.06.83

(30) Priority: 16.06.82 JP 102018/82
16.06.82 JP 102019/82

(43) Date of publication of application: 28.12.83
Bulletin 83/52

(84) Designated Contracting States: DE GB

(71) Applicant: HITACHI, LTD., 6, Kanda Surugadai 4-chome
Chiyoda-ku, Tokyo (JP)

(72) Inventor: Hatada, Koichi, 3-4-11, Asahigaoka, Ikeda-shi
Osaka-fu (JP)
Inventor: Yuki, Heimei, 9-11, Oomino, Sakai-shi Osaka-fu
(JP)

(74) Representative: Dost, Wolfgang, Dr.rer.nat., Dipl.-Chem.
et al, Patent- und Rechtsanwälte
Bardehle-Pagenberg-Dost-Altenburg & Partner
Postfach 86 06 20, D-8000 München 86 (DE)

(54) **Positive type radiation-sensitive organic highpolymer material and method of forming fine pattern by using the same.**

(57) A positive type radiation-sensitive copolymer of at least two aliphatic aldehyde monomers having the general formula R–CHO wherein R denotes an alkyl group, a halogenated alkyl group, an aralkyl group or a halogenated aralkyl group. Exhibiting high sensitivity to high energy radiation, is used for the formation of fine patterns required for producing semiconductor devices, magnetic bubble memory devices, integrated circuits, etc.

EP 0 096 895 A2

Hitachi, Ltd.

June 14, 1983
H 4676-EP

Title of the Invention

POSITIVE TYPE RADIATION-SENSITIVE ORGANIC HIGH-POLYMER MATERIAL AND METHOD OF FORMING FINE PATTERN BY USING THE SAME

Background of the Invention

Field of the Invention

The present invention relates to a positive type radiation-sensitive organic high-polymer material which exhibits high sensitivities to radiations of high energy such as electron beam, X-ray and ion beam and which is suited to the formation of fine patterns required for fabricating a semiconductor device, a magnetic bubble memory device, an IC, etc. It also relates to a method of forming the fine patterns by using the aforementioned material.

Description of the Prior Art

In recent years, in order to render semiconductor devices, IC's etc. high integration and packaging densities, it is required to form fine patterns which are not wider than 1 μm.

Lithographic techniques employing radiations of high energy such as electron beam, X-ray and ion beam have been studied and developed for forming the fine patterns as stated above. Resists are classified into (a) a positive type radiation-sensitive organic

high-polymer material, such as poly(methyl methacrylate) or poly(1-butene sulfone), which induces the reaction of severing a high-polymer chain upon irradiation with, the radiation, and the irradiated part of which becomes soluble in a developing solution, thereby to form the pattern, and (b) a negative type radiation-sensitive organic high-polymer material, which cross-links by the radiation, and the irradiated part of which becomes insoluble in a developing solution, thereby to form the pattern.

The positive type material (a) is higher in resolution than the negative type material (b). Since, however, the former has as low a sensitivity as $\frac{1}{10} - \frac{1}{1000}$ of that of the latter, it requires a long time for forming the fine pattern (refer to Japanese Patent Application Publication No. 57-24801).

Summary of the Invention

An object of the present invention is to provide a positive type radiation-sensitive organic high-polymer material which has high sensitivities to radiations of high energy such as electron beam, X-ray and ion beam, which has a high resolution, and whose part irradiated with the radiation depolymerizes in chain-reacting fashion and evaporates, so that any special developing step is dispensed with, and

also a method of forming a fine pattern on a substrate by using the positive type material.

In order to accomplish the object, various organic high-polymer materials were studied. As a result, it has been revealed that an aliphatic aldehyde polymer obtained by copolymerizing at least two kinds of aliphatic aldehydes is favorable.

Now, materials for use in the present invention will be described.

In general, the polymer of a single aliphatic aldehyde is difficult to dissolve in many organic solvents because of its high crystallinity, so that it cannot be used as a resist material. On the other hand, it is known that when a mixture consisting of at least two kinds of aliphatic aldehydes is subjected to anionic polymerization, an aldehyde copolymer having an improved solubility is produced (refer, for example, to 'Kōbunshi-Kagaku (polymer chemistry)', 21, 694 (1963) by Tanaka et al.). This material has been found usable as a radiation-sensitive organic high-polymer material.

Aliphatic aldehyde monomers to form a mixture for use in the present invention are at least two kinds of aldehyde monomers selected from the group consisting of aliphatic aldehydes expressed by a

general formula, R-CHO where R denotes an alkyl group, a halogenated alkyl group, an aralkyl group or a halogenated aralkyl group. Especially preferable are aliphatic aldehydes of the alkyl group, the halogenated alkyl group, the aralkyl group or the halogenated aralkyl group having an aliphatic carbon number of 1 to 8. When the mol ratio of the mixture are controlled in terms of the composition of the polymer, they are selected from within a composition range within which the component of the largest ratio contained in the copolymer does not exceed 99 mol-% Particularly for obtaining a copolymer of high solubility, it is desirable that the component of the largest ratio contained in the copolymer does not exceed 80 mol-%.

The polymer is produced by the anionic polymerization. Used as a polymerization initiator is any of dimethylaluminum diphenylamide $(CH_3)_2AlN(C_6H_5)_2$, diethylaluminum diphenylamide $(C_2H_5)_2AlN(C_6H_5)_2$, ethylaluminum bis(diphenylamide) $(C_2H_5)Al[N(C_6H_5)_2]_2$, ethylzinc diphenylamide $C_2H_5ZnN(C_6H_5)_2$ ethylmagnesium diphenylamide $C_2H_5MgN(C_6H_5)_2$, etc.

The amount of addition of the catalyst is a proportion of 0.1 - 5 mol-% with respect to the aldehyde monomer mixture.

In a case where the polymerization initiator is needed in carrying out the anionic polymerization, a hydrocarbon type solvent such as toluene or an ethyl ether type solvent is used.

The polymerization is performed at a temperature in a range of 0°C to -100°C. Usually, a temperature of -50°C to -80°C is preferable.

Further, as the atmosphere of the polymerization, it is recommended to substitute the air sufficiently in a reactor by an inert gas such as dry nitrogen.

Concretely, the anionic polymerization is conducted in such a way that the initiator is dissolved in the inactive organic solvent, whereupon the aldehyde mixture is subjected to reduced-pressure distillation in the initiator solution, or that the initiator itself or a solution thereof is added to the aldehyde mixture itself or a solution thereof, whereupon the resultant system is incubated.

When the radiation-sensitive organic high-polymer material thus produced is used for forming the pattern of a semiconductor device or the like, the material dissolved in a conventional organic solvent, for example, toluene or xylene is applied on the substrate of the element by spin coating or dip coating.

After the applied material has been prebaked under

a suitable temperature condition, it is irradiated with radiation in a desired pattern. Then, the irradiated part disintegrates in chain-reacting fashion and evaporates, whereby the positive type resist pattern is obtained without performing any developing process.

If necessary, wet development may well be performed using a toluene-isopropyl alcohol type organic solvent.

If necessary, the radiation-sensitive organic high-polymer material composed of the aldehyde polymer according to the present invention may well be mixed in use with novolak resin, polyacrylate ester type polymer, polyisoprene resin, polystyrene, etc. In this case, a developing solution is selected depending upon the mixed polymer, and the characteristics, e.g., dry-etching resistance can be variously changed.

While the aldehyde polymer of the present invention exhibits high sensitivities to radiations, it is also sensitive to light and usable as a photosensitive material.

Brief Description of the Drawings

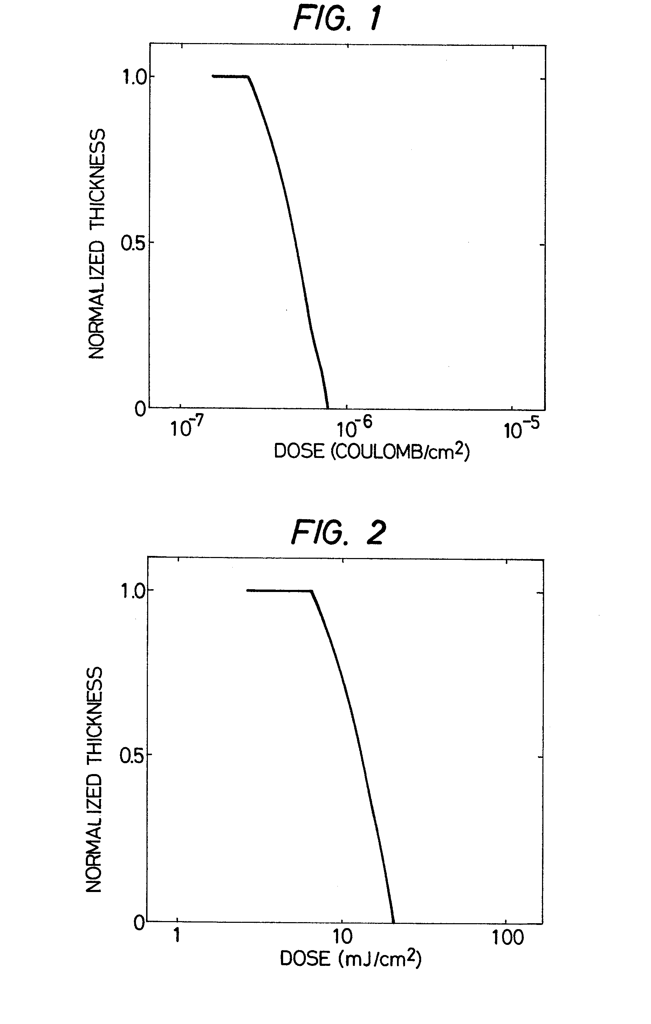

Figure 1 is a graph showing the electron beam exposure characteristic of a radiation-sensitive

high-polymer material according to the present invention, while Figure 2 is a graph showing the soft X-ray exposure characteristic of a radiation-sensitive high-polymer material according to the present invention.

Description of the Preferred Embodiments

Now, the present invention will be concretely described in conjunction with examples of synthesis and examples of performance.

Example of Synthesis 1:

The synthesis of diethylaluminum diphenylamide, $(C_2H_5)_2A\ell N(C_6H_5)_2$, was carried out as stated below.

After the air in a four-necked flask of 200 mℓ provided with an agitator, a dropping funnel, a three-way stopcock and a thermometer was sufficiently substituted by nitrogen, 33 mℓ of toluene and 14.5 gr (0.127 mol) of $(CH_3CH_2)_3A\ell$ were introduced into the flask through the three-way stopcock with a hypodermic syringe under a nitrogen atmosphere.

After the resultant liquid was stirred for a while into a uniform solution, a solution with 21.4 gr (0.127 mol) of diphenylamine dissolved in 40 mℓ of toluene was slowly added thereinto under an ice cold condition. After the end of the addition, a reaction product had its temperature raised to 60°C and was gently stirred in that condition for 2 hours. Then,

the reaction was completed. The produced $(C_2H_5)_2Al N-(C_6H_5)_2$ was left as the toluene solution and stored in a container with a three-way stopcock under a nitrogen pressure.

Examples of Synthesis 2 - 8:

Polymerization was carried out by the use of a polymerizing tube provided with a three-way stopcock. Predetermined amounts of aldehyde monomers and solvent (usually, toluene was used) were introduced into the cylindrical polymerizing vessel having a capacity of about 100 mℓ, through the three-way stopcock with a syringe under a nitrogen stream. While the reaction vessel containing the monomer solution was being violently moved in the state in which it was cooled to $0^{o}C$ by an ice - water bath, a predetermined amount of the initiator solution produced in Example of Synthesis 1 was gradually added into the vessel.

After the addition of the initiator, the vessel was cooled to $-78^{o}C$ by a dry ice - acetone bath, and the monomer solution was allowed to polymerize for a predetermined period of time. Then the polymerization mixture was treated with ammoniac methanol so as to terminate the reaction and decompose the unreacted initiator. Thereafter, it was immersed in a large amount of methanol for 1 day and then the

precipitated polymer was collected by filtration. The polymer was washed with methanol several times, and dried under vacuum.

In some cases, the monomer solution was added into the catalyst solution and polymerized.

Polymers of various compositions thus synthesized are listed in Table 1.

The composition ratio of each copolymer was evaluated by the elementary analysis or the analysis of the monomer mixture produced by the thermal decomposition of the polymer under high vacuum at elevated temperature.

Table 1

| Examples of Synthesis | Monomer Mixture Composition (mol ratio) | Polymer yield (%) | Polymer Composition (mol % of AA) |
|---|---|---|---|
| Ex. of Syn. 2 | AA (50) - BA (50) | 65 | 46 |
| " 3 | AA (40) - BA (60) | 73 | 39 |
| " 4 | AA (60) - BA (40) | 59 | 58 |
| " 5 | AA (80) - BA (20) | 42 | 81 |
| " 6 | PhPA (50) - PA (50) | 43 | 52 (mol % of PA) |
| " 7 | HA (50) - AA (50) | 58 | 56 |
| " 8 | AA(33)-BA(33)-IBA(33) | 56 | AA(26)-BA(36)-IBA(38) |

Polymerization time: 24 hours, total monomer quantity: 100 mmol, solvent: toluene, total volume of reaction mixture: 27 mℓ, initiator $(C_2H_5)_2AlN(C_6H_5)_2$: 0.18 mmol.

-Symbols of Monomers-AA: acetaldehyde

BA: butyraldehyde

PA: propanal

PhPA: 3-phenylpropanal

HA: heptanal

IBA: isobutyraldehyde

Example of Performance 1:

The acetaldehyde - butyraldehyde copolymer obtained in Example of Synthesis 2 was dissolved in xylene, to prepare a 0.2 weight-% resist solution.

Subsequently, the resist solution was applied on a silicon wafer by dip coating and was prebaked at 80°C for 20 minutes, to form a high-polymer film of 1.5 μm thickness.

The resultant wafer was put into an electron beam irradiation apparatus, and the film was irradiated with an electron beam at an acceleration voltage of 20 kV under vacuum, with doses differing depending upon places.

As a result, the irradiated part of the film decreased without any developing treatment. Regarding

the places irradiated with the various doses, the thicknesses of the residual high-polymer film were measured with a Talystep film thickness gauge, and the residual film thicknesses (normalized) were plotted against the electron beam doses (coulomb/$cm^2$). Then, Figure 1 expressive of the electron beam sensitivity characteristic of the high-polymer film was obtained. When the minimum dose with which the remaining film thickness became null was evaluated from the characteristic, it was $8 \times 10^{-7}$ C/$cm^2$. It has accordingly been verified that the high-polymer film is a positive type resist of very high sensitivity. For example, poly(methyl methacrylate) which is a typical positive type resist has an electron beam sensitivity of $1 \times 10^{-4}$ C/$cm^2$. It has therefore been verified that, as compared with the poly(methyl methacrylate), the positive type resist material of the present invention exhibits the sensitivity of more than 100 times higher than that of poly(methyl methacrylate).

Example of Performance 2:

The acetaldehyde - butyraldehyde copolymer obtained in Example of Synthesis 2 was dissolved in toluene, to prepare a 0.3 weight-% resist solution.

Subsequently, the resist solution was applied on a silicon wafer by dip coating and was prebaked at

80°C for 20 minutes, to form a high-polymer film of 2.0 μm thickness.

The resultant wafer was put into a soft X-ray generator, the film was irradiated under vacuum with soft X-ray of a wavelength of 4.2 Å emitted from a water-cooled rotary silver target of 10 kW, and the relationship between residual film thicknesses (normalized) and soft X-ray doses ($mJ/cm^2$) was evaluated. The result is shown in Figure 2. The minimum dose affording the null film thickness was found to be 19 $mJ/cm^2$, and the high-polymer film has been verified to be a positive type resist of very high sensitivity.

For example, poly(methyl methacrylate) which is a typical positive type resist has a soft X-ray sensitivity of about 2000 $mJ/cm^2$. It has therefore been verified that, as compared with the poly(methyl methacrylate), the positive type resist material of the present invention has the soft X-ray sensitivity which is more than 100 times higher than that of poly(methyl methacrylate).

Examples of Performance 3 - 8:

The aldehyde copolymer obtained in each of Examples of Syntheses 3 - 8 was dissolved in xylene, to prepare a resist solution of about 0.2 weight-%.

Subsequently, the resist solution was applied on a silicon wafer by dip coating and was prebaked at 80°C for 20 minutes, to form a high-polymer film having a thickness of about 1.5 μm.

Next, the high-polymer film was irradiated with an electron beam having an acceleration voltage of 20 kV or soft X-rays (AℓKα or AgLα) of 10 kW so as to evaluate an electron beam sensitivity or a soft X-ray sensitivity.

Results on the aldehyde copolymers are collectively indicated in Table 2. It has been verified that all the materials are highly sensitive to the radiations and are positive type resists of high sensitivities.

Table 2

| Examples of Performance | Radiation-sensitive High-polymer Material *) | Electron beam sensitivity ($C/cm^2$) or Soft X-ray sensitivity ($mJ/cm^2$) |
|---|---|---|
| Ex. of Per. 3 | AA (39) - BA (61) | $7 \times 10^{-7}$ $C/cm^2$ |
| " 4 | AA (58) - BA (42) | 15 $mJ/cm^2$ (A$\ell$K$\alpha$) |
| " 5 | AA (81) - BA (19) | 20 $mJ/cm^2$ (A$\ell$K$\alpha$) |
| " 6 | PhPA (48) - PA (52) | $5 \times 10^{-7}$ $C/cm^2$ |
| " 7 | HA (44) - AA (56) | 10 $mJ/cm^2$ (AgL$\alpha$) |
| " 8 | AA(26) - BA(36) - IBA(38) | $8 \times 10^{-7}$ $C/cm^2$ |

*) Numerical values in parentheses denote mol ratios in the copolymers.

-Symbols of Monomers-

AA: acetaldehyde

BA: butyraldehyde

PA: propanal

PhPA: 3-pehnylpropanal

HA: heptanal

IBA: isobutyraldehyde

Comparative Examples:

Likewise to the examples of performance, polymers of single acetaldehyde or single butyraldehyde were assessed as resist materials. However, any of the samples did not dissolve in the conventional organic solvent and could not be put into practical use.

## CLAIMS

1. A positive type radiation-sensitive organic high-polymer material comprising a copolymer which is obtained by copolymerizing at least two kinds of compounds selected from the group consisting of aliphatic aldehyde monomers indicated by a general formula (1):

R-CHO (1)

(where R denotes an alkyl group, a halogenated alkyl group, an aralkyl group or a halogenated aralkyl group)

and which has such a composition range that its constituent of the largest amount does not exceed 99 mol-%.

2. A positive type radiation-sensitive organic high-polymer material as defined in claim 1, wherein the constituent of said copolymer having the largest amount does not exceed 80 mol-%.

3. A positive type radiation-sensitive organic high-polymer material as defined in claim 1 or 2, wherein the group denoted by R is the alkyl group the halogenated alkyl group, the aralkyl group or the halogenated aralkyl group having an aliphatic carbon number of 1 to 8.

4. A positive type radiation-sensitive organic high-polymer material of any of claims 1 - 3, wherein said at least two kinds of compounds selected from the

group consisting of aliphatic aldehyde monomers indicated by said general formula (1) are:

(a) acetaldehyde and butyraldehyde,

(b) 3-phenylpropanal and propanal,

(c) heptanal and acetaldehyde, or

(d) acetaldehyde, butyraldehyde and isobutyraldehyde.

5. A method of forming a fine pattern comprising the step of coating a substrate with a positive type radiation-sensitive organic high-polymer material which is obtained by copolymerizing at least two kinds of compounds selected from the group consisting of aliphatic aldehyde monomers indicated by a general formula (1):

R-CHO (1)

(where R denotes an alkyl group, a halogenated alkyl group, an aralkyl group or a halogenated aralkyl group)

and which has such a composition range that its constituent of the largest amount does not exceed 99 mol-%, and the step of exposing the coating to radiation by properly masking it.

6. A method of forming a fine pattern as defined in claim 5, wherein the constituent of the copolymer having the largest amount does not exceed 80 mol-%.

7. A method of forming a fine pattern of any of

claims 5-6, wherein the group of the copolymer denoted by R is the alkyl group, the halogenated alkyl group, the aralkyl group or the halogenated aralkyl group having an aliphatic carbon number of 1 to 8.

8. A method of forming a fine pattern of any of claims 5-8, wherein said at least two kinds of compounds selected from the group consisting of aliphatic aldehyde monomers indicated by said general formula (1) are:

(a) acetaldehyde and butyraldehyde,

(b) 3-phenylpropanal and propanal,

(c) heptanal and acetaldehyde, or

(d) acetaldehyde, butyraldehyde and isobutyraldehyde.

0096895

1/1

FIG. 1

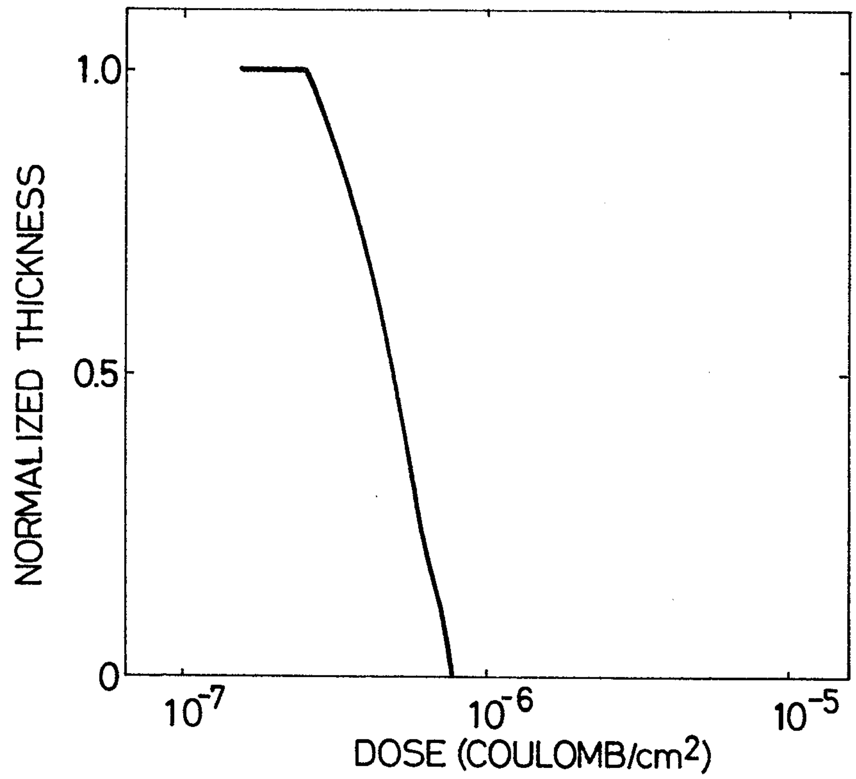


FIG. 2